# EUROPEAN PATENT SPECIFICATION

(11) **EP 2 971 224 B1**
(45) Date of publication and mention of the grant of the patent: **31.01.2018**
(21) Application number: 13711866.7
(22) Date of filing: 15.03.2013
(51) Int. Cl.: C23C 14/50, C03C 17/00

(54) **CARRIER FOR SUBSTRATES**
TRÄGER FÜR SUBSTRATE
SUPPORT POUR SUBSTRATS

(43) Date of publication of application: 20.01.2016
(73) Proprietor: Applied Materials, Inc., Santa Clara, CA 95054 (US)
(72) Inventor: HEIMEL, Oliver, 34590 Wabern (DE); LINDENBERG, Ralph, 63654 Büdingen (DE); WURSTER, Harald, 63776 Mömbris (DE); ZENGEL, Claus, 63785 Obernburg (DE)
(74) Representative: Zimmermann & Partner Patentanwälte mbB
(86) International application number: PCT/EP2013/055440
(87) International publication number: WO 2014/139591

(56) References cited:
- JP-A- H1 072 668
- US-A1- 2010 151 680

## Description

### TECHNICAL FIELD OF THE INVENTION

Embodiments of the present invention relate to carriers for substrate processing, e.g., for layer deposition. Embodiments of the present invention particularly relate to carriers for supporting a large area substrate in a substrate processing machine and apparatuses for processing a large area substrate.

### BACKGROUND OF THE INVENTION

Several methods are known for depositing a material on a substrate. For instance, substrates may be coated by a physical vapor deposition (PVD) process, a chemical vapor deposition (CVD) process, a plasma enhanced chemical vapor deposition (PECVD) process etc. Typically, the process is performed in a process apparatus or process chamber, where the substrate to be coated is located. A deposition material is provided in the apparatus. A plurality of materials, but also oxides, nitrides or carbides thereof, may be used for deposition on a substrate. Further, other processing steps like etching, structuring, annealing, or the like can be conducted in processing chambers.

Coated materials may be used in several applications and in several technical fields. For instance, an application lies in the field of microelectronics, such as generating semiconductor devices. Also, substrates for displays are often coated by a PVD process. Further applications include insulating panels, organic light emitting diode (OLED) panels, substrates with TFT, color filters or the like.

Particularly for areas such as display production, manufacturing of thin-film solar cells and similar applications, large area glass substrates are used to be processed. In the past, there has been a continuous increase in substrate sizes which is still to be continued. The increasing size of glass substrates makes the handling, supporting and processing thereof, without sacrificing the throughput by glass breakage, increasingly challenging.

Typically, glass substrates can be supported on carriers during processing thereof. A carrier drives the glass or the substrate through the processing machine. The carriers typically form a frame or a plate, which supports a surface of the substrate along the periphery thereof or, in the latter case, supports the surface as such. Particularly, a frame shaped carrier can also be used to mask a glass substrate, wherein the aperture in the carrier, which is surrounded by the frame, provides an aperture for coating material to be deposited on the exposed substrate portion or an aperture for other processing steps acting on the substrate portion, which is exposed by the aperture. US2010/0151680 A and JP 10-072668 A show substrate carriers in which the substrate is supported near its periphery.

The tendency to larger and also thinner substrates can result in bulging of the substrates, in particular due to stress applied to the substrate during deposition of the layers, whereby bulging can, in turn, cause problems due to the increasing likelihood of breakage. Moreover, bulging can reduce quality, e.g., uniformity, of the material layers deposited. Accordingly, there is a desire to reduce bulging and to enable a carrier to transport bigger and thinner substrates without breakage, and to improve the quality of the coated material layers.

In view of the above, it is an object of the present invention to provide a carrier, particularly a carrier having a fixation assembly that overcomes at least some of the problems in the art.

### SUMMARY OF THE INVENTION

In light of the above, a carrier for supporting a substrate according to independent claim 1 is provided. Further aspects, advantages, and features of the present invention are apparent from the dependent claims, the description, and the accompanying drawings.

According to one embodiment, a carrier for supporting a substrate in a substrate processing chamber is provided. The carrier includes a substrate fixation assembly, wherein the substrate fixation assembly includes one or more fixation units, wherein each fixation unit includes: an edge contacting surface configured for contacting the edge of the substrate and defining a contact position; a first fixation element having a first surface configured for contacting a first substrate surface of the substrate, wherein the first fixation element extends from the contact position by a first length L1 substantially parallel to the first substrate surface; a second fixation element having a second surface configured for contacting a second substrate surface of the substrate, wherein the second substrate surface opposes the first substrate surface of the substrate, and wherein the second fixation element extends from the contact position by a second length L2 substantially parallel to the second substrate surface; a force element for providing a fixation force for the substrate with at least one of the first and the second fixation element; wherein the shorter length of the first length and the second length provide in combination with the fixation force a moment. The one or more fixation units provide the moment to be 10 Nmm per substrate edge length unit, measured in meters, or above.

According to another aspect, an apparatus for depositing a layer on a large area glass substrate is provided, including: a vacuum chamber adapted for layer deposition therein, a transport system adapted for transportation of a carrier. The carrier includes a substrate fixation assembly, wherein the substrate fixation assembly includes one or more fixation units, wherein each fixation unit includes: an edge contacting surface configured for contacting the edge of the substrate and defining a contact position; a first fixation element having a first surface configured for contacting a first substrate surface of the substrate, wherein the first fixation element extends from the contact position by a first length L1 substantially parallel to the first substrate surface; a second fixation element having a second surface configured for contacting a second substrate surface of the substrate, wherein the second substrate surface opposes the first substrate surface of the substrate, and wherein the second fixation element extends from the contact position by a second length L2 substantially parallel to the second substrate surface; a force element for providing a fixation force for the substrate with at least one of the first and the second fixation element; wherein the shorter length of the first length and the second length provide in combination with the fixation force a moment. The one or more fixation units provide the moment to be 10 Nmm per substrate edge length unit, measured in meters, or above. The apparatus further includes a deposition source for depositing material forming the layer.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- FIGs. 1A, 1B, 1C and 1D: illustrate carriers according to embodiments described herein, each having a fixation assembly, and with a substrate provided in a substrate area of the carrier;
- FIG. 2: shows an example of a fixation unit of a carrier according to embodiments described herein;
- FIG. 3: shows another example of a fixation unit of a carrier according to embodiments described herein; and
- FIG. 4: shows a view of an apparatus for depositing a layer of material on a substrate utilizing a carrier according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

According to embodiments, described herein a carrier having a substrate fixation assembly is provided. Thereby, the fixation assembly is configured to reduce bending or bulging of the substrate due to stress, particularly stress introduced by depositing layers on the substrate. The substrate fixation assembly provides a two-part clamp having a first fixation element and a second fixation element. The two-part clamp counteracts a bending of the substrate by a sufficient moment, e.g. per unit length of the substrate edge. Accordingly, the substrate edge region is maintained in an orientation parallel to the carrier surface and a deformation corresponding to a rotation of the substrate with an axis corresponding to the substrate edge can be avoided or reduced.

According to embodiments described herein, the substrate fixation assembly includes one or more fixation units. They can be distributed around the perimeter of the substrate to effectively avoid or reduce bending or bulging of the substrate. Each fixation unit includes an edge contacting surface configured for contacting the edge of the substrate and defining a contact position; a first fixation element having a first surface configured for contacting a first substrate surface of the substrate, wherein the first fixation element extends from the contact position by a first length L1 substantially parallel to the first substrate surface; a second fixation element having a second surface configured for contacting a second substrate surface of the substrate, wherein the second substrate surface opposes the first substrate surface of the substrate, and wherein the second fixation element extends from the contact position by a second length L2 substantially parallel to the second substrate surface. The shorter length of the first length and the second length provide one aspect to be considered for counteracting the moment of the stress of the substrate. Further, a force element, e.g. a spring or the like, is provided and is configured to apply a fixation force for the substrate with at least one of the first and the second fixation element. The force and the smaller length provide, in combination, a moment to avoid bending or bulging of the substrate.

According to typical embodiments, which can be combined with other embodiments described herein, the substrate thickness can be from 0.1 to 1.8 mm and the fixation elements can be adapted for such substrate thicknesses. However, particularly beneficial is if the substrate thickness is about 0.9 mm or below, such as 0.7 mm, 0.5 mm or 0.3 mm and the fixation elements are adapted for such substrate thicknesses.

According to some embodiments, large area substrates may have a size of at least 0.174 m². Typically the size can be about 1.4 m² to about 8 m², more typically about 2 m² to about 9 m² or even up to 12 m². Typically, the rectangular substrates, for which the mask structures, apparatuses, and methods according to embodiments described herein are provided, are large area substrates as described herein. For instance, a large area substrate can be GEN 5, which corresponds to about 1.4 m² substrates (1.1 m x 1.3 m), GEN 7.5, which corresponds to about 4.39 m² substrates (1.95 m x 2.25 m), GEN 8.5, which corresponds to about 5.5 m² substrates (2.2 m x 2.5 m), or even GEN 10, which corresponds to about 8.7 m² substrates (2.85 m x 3.05 m). Even larger generations such as GEN 11 and GEN 12 and corresponding substrate areas can similarly be implemented.

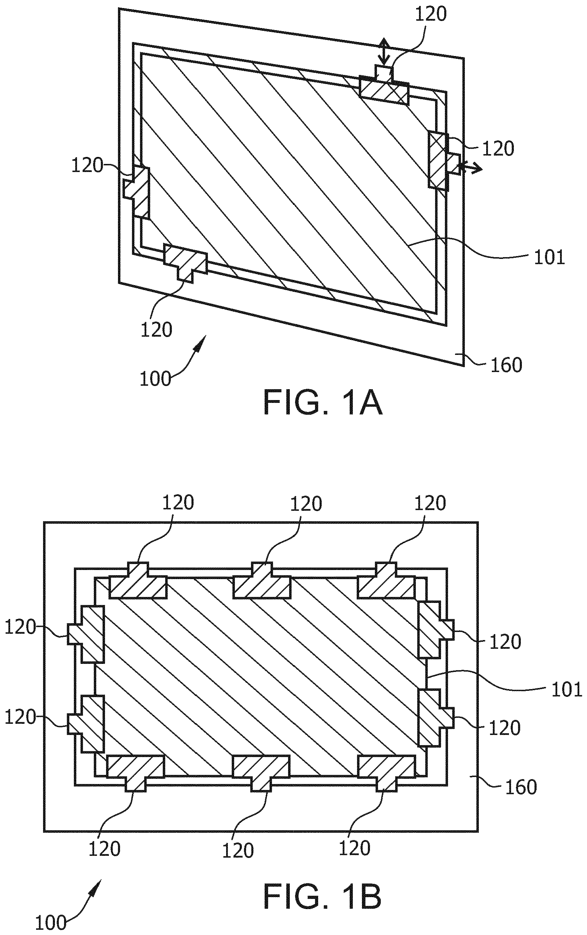

FIG. 1A shows a carrier 100. The carrier 100 is configured for supporting a large area substrate 101. As shown in FIG. 1A, the substrate 101 is provided in a position within the carrier 100, particularly when processed in a processing chamber. The carrier 100 includes a frame 160 defining a window or aperture. According to typical implementations the frame provides a substrate receiving surface. Typically, the substrate receiving surface is configured to be in contact with a perimeter portion of the substrate during operation, i.e. when the substrate is loaded.

Typically, the substrate 101 may be made from any material suitable for material deposition. For instance, the substrate may be made from a material selected from the group consisting of glass (for instance soda-lime glass, borosilicate glass etc.), metal, polymer, ceramic, compound materials or any other material or combination of materials which can be coated by a deposition process. The bulging, which might also affect the processing of the substrate, can be reduced by the carriers according to embodiments described herein. Particularly for glass substrates or ceramic substrates, where breakage is a further concern, the carriers can also significantly reduce substrate breakage which reduces the productivity of the production process due to the increased loss. However, as bulging might also result in other problems, other substrates can also beneficially utilize embodiments described herein.

According to some embodiments, the frame 160 can be made of aluminum, aluminum alloys, titanium, alloys thereof, stainless steel or the like. For comparably small large area substrates, e.g. GEN 5 or below, the frame 160 can be manufactured from a single piece, i.e. the frame is integrally formed. However, according to some embodiments, which can be combined with other embodiments described herein, the frame 160 can include two or more elements such as a top bar, sidebars and a bottom bar. Thereby, particularly for very large area substrates, the carrier can be manufactured having several portions. These portions of the carrier are assembled to provide the frame 160 for supporting the substrate 101. The frame 160 is particularly configured for receiving the substrate 101 in the substrate area.

The carrier 100 shown in FIG. 1A further includes a fixation assembly. The fixation assembly includes fixation units 120. In the example shown in FIG. 1A two fixation units 120 are provided in a left lower edge portion of the frame 160. According to some embodiments, said two fixation units 120 in the left lower edge portion of the frame 160 are fixed in position and not moveable.

Although two fixation units 120 in the left lower edge portion of the frame 160 are shown in FIG. 1A, the present invention is not limited thereto. More than two fixation units 120 could be provided in the left lower edge portion of the frame 160. For instance, more than one fixation unit 120 could be provided on each side of the substrate 101.

According to some embodiments, which can be combined with other embodiments described herein, two fixation units 120 are provided in a right upper edge portion of the frame 160. According to some embodiments, the two fixation units 120 in the right upper edge portion of the frame 160 are moveable substantially parallel to the substrate area, i.e. substantially parallel to the surfaces of the substrate, and perpendicular to the edge of the substrate 101 as indicated by the arrows.

Although two fixation units 120 in the right upper edge portion of the frame 160 are shown in FIG. 1a, the present invention is not limited thereto. More than two fixation units 120 could be provided in the right upper edge portion of the frame 160. For instance, more than one fixation unit 120 could be provided on each side of the substrate 101.

By providing non-movable fixation units 120 in the left (or right) lower edge portion of the substrate 101, and by providing moveable fixation units 120 in the right (or left) upper edge portion of the substrate 101, a position of the substrate 101 within the substrate area defined by the frame 160 can be precisely adjusted. According to some embodiments, which can be combined with other embodiments described herein, the carriers described herein and the apparatuses for utilizing the carriers described herein, are for vertical substrate processing. Thereby, the term vertical substrate processing is understood to distinguish over horizontal substrate processing. That is, vertical substrate processing relates to an essentially vertical orientation of the carrier and the substrate during substrate processing, wherein a deviation of a few degrees, e.g. up to 10° or even up to 15°, from an exact vertical orientation is still considered as vertical substrate processing. A vertical substrate orientation with a small inclination can for example result in a more stable substrate handling.

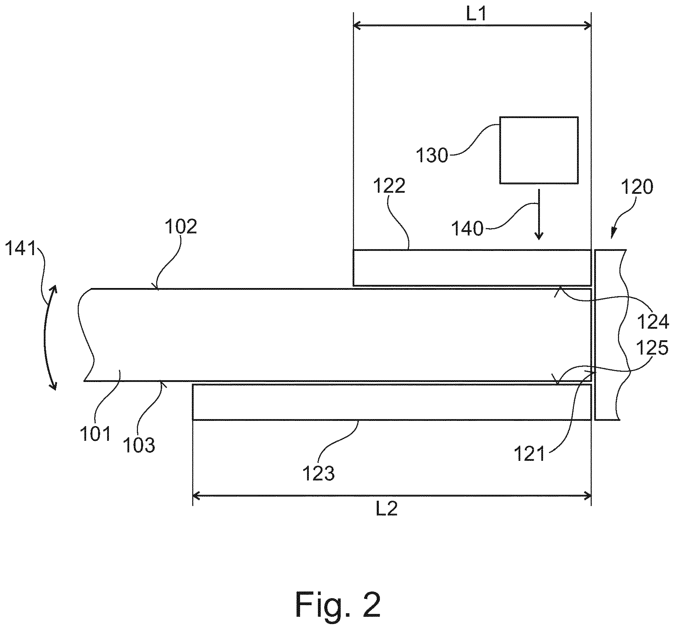

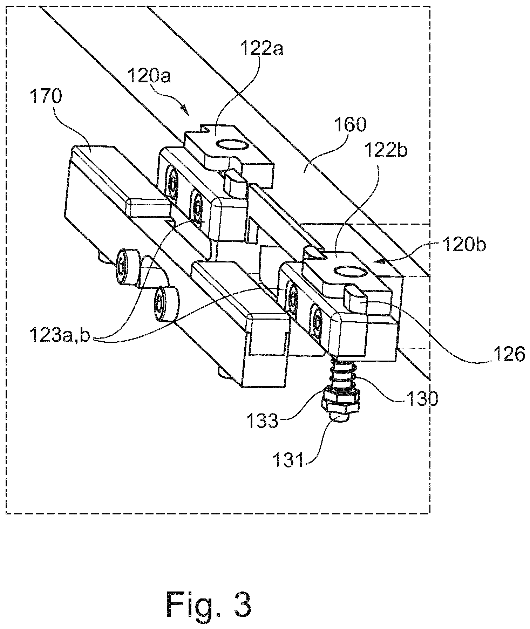

According to embodiments described herein, and as described in more details with respect to FIGS. 2 and 3, the fixation unit provides at least a moment to counteract bending of the substrate in the perimeter region thereof. Additionally, the fixation element can provide holding or supporting forces for supporting the substrate stably in the carrier. The moment of the fixation unit is provided by at least two surfaces configured to be provided on opposing sides of the substrate, wherein the at least two surfaces provide a lever arm and are pressed together for providing the desired moment counteracting the bending or bulging of the substrate.

FIG. 1B shows another example of a carrier 100 according to some embodiments. The embodiment shown in FIG. 1B is similar to the embodiment shown in FIG. 1a. The carrier 100 of FIG. 1b includes fixation units 120 in more than two, preferably in all, edge portions of the substrate 101. According to some embodiments, one or more of the fixation units 120 are moveable. Further, all fixation units 120 could be provided moveable.

In order to reduce bending or bulging of the substrate it is beneficial, particularly for large area substrates as defined herein, which are typically rectangular, that all edges of the substrate are prevented from bending. According to some embodiments, which can be combined with other embodiments described herein, thus, at least one fixation unit is provided on at least two sides of the frame 160 and optionally even on each side of the frame 160.

According to further embodiments, which can additionally or alternatively be implemented, the positions at which a counteracting moment is applied are distributed around the perimeter of the substrate for example uniformly distributed. For example, a counteracting moment can be provided every 50 mm to every 500 mm, such as every 100 to 300 mm around the edge of the substrate. Typically, the counteracting moment can also be provided in pairs of positions as will be easier understood with respect to FIG. 3. For example, a GEN8.5 substrate might be reduced in bending by counteracting the moment at 56 positions or 28 pairs of positions respectively.

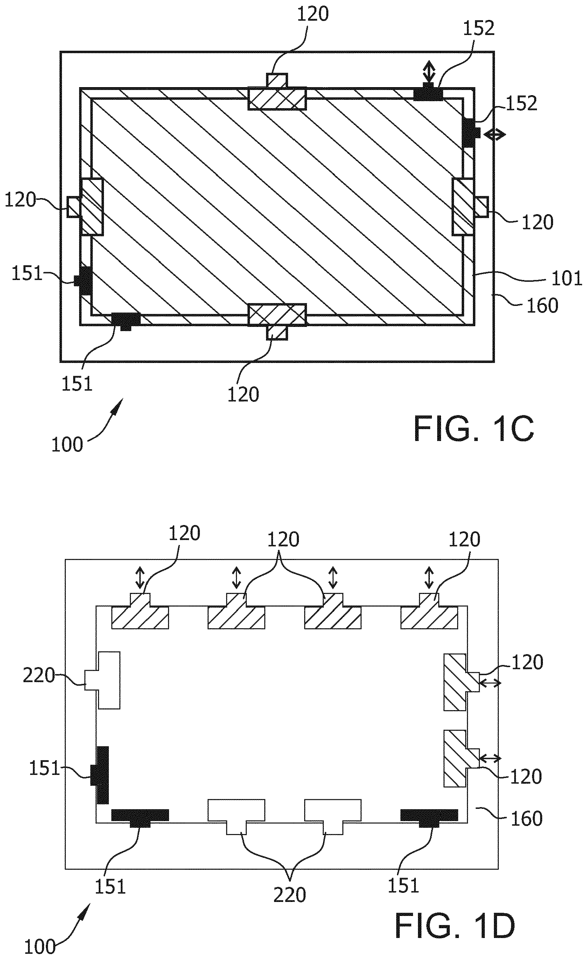

FIG. 1C shows another example of a carrier 100 according to some embodiments, which can be combined with other embodiments described herein. The example shown in FIG. 1C is similar to the embodiments shown in FIGS. 1A and 1B. The carrier of FIG. 1C includes first positioning elements 151 and second positioning elements 152 for positioning the substrate 101 in the substrate area. The first positioning elements 151 may be fixedly attached to the frame 160. One or more first positioning elements 151 may be provided.

The second position elements 152 may be movable substantially parallel to the substrate area, i.e. substantially parallel to the surfaces of the substrate, and perpendicular to a respective edge of the substrate 101. Hereby, a position of the substrate 101 within the substrate area defined by the frame 160 can be precisely adjusted.

For example, the first and second positioning elements 151, 152 may include clamps or guiding means. According to some embodiments, positioning elements 151, 152 as exemplarily shown on FIG. 1C, e.g. at the side or bottom, may be designed such that they do not essentially contribute to the compensation of forces resulting from bending or bulging of the substrate. Rather, they are adapted to avoid free movement of the substrate 101 and/or are provided to support the substrate in the substrate receiving surface of the frame 160.

The carrier 100 further includes a fixation assembly. The fixation assembly includes at least one fixation unit 120, e.g. on a top side or upper side of the frame 160. Four fixation units 120 for reducing bending of the substrate are illustrated in FIG. 1C. However, the number of fixation units and corresponding fixation positions can be adapted according to the embodiments described herein. According to some embodiments one or more fixation units 120 are provided. Particularly, one or more fixation units 120 can be provided on one or more sides of the substrate, as it is for instance shown in FIGS. 1A and 1.

FIG. 1D shows a further carrier 100. The carrier 100 is configured for supporting a large area substrate. The carrier of FIG. 1D includes first positioning elements 151 for positioning the substrate 101 in the substrate area and is configured to provide for a predetermined substrate position. The first positioning elements 151 may be fixedly attached to the frame 160. According to some embodiments, which can be combined with other embodiments described herein, one or more first positioning elements 151, which are fixedly attached to the frame are provided.

According to some embodiments, which can be combined with other embodiments described herein, three first position elements 151 are provided. Thereby, the position of the substrate is fully determined. Further, the position is not over-determined as for example by utilizing four or more first position elements 151. Typically, two fixedly connected first positioning elements are provided at the bottom portion of the frame and one first positioning element is provided at one side portion of the frame. The first positioning element can have a gap for substrate insertion or other means for arranging the substrate in the first positioning element, wherein an edge contacting surface configured for contacting the edge of the substrate and defining a contact position is provided. The contact position thereby defines the predetermined substrate position in the carrier.

The carrier 100 shown in FIG. 1D further includes fixation units 120, which are movable with respect to the perimeter of the carrier frame, i.e. parallel to the surface of a substrate received in the carrier. These fixation units are described in more detail with respect to FIGS. 2 and 3. According to typical embodiments, which can be combined with other embodiments described herein, they are provided and/or distributed along the sides of the frame 160, which opposes a side at which a first positioning element is provided.

According to some embodiments, which can be combined with other embodiments described herein, further fixation units 220 can be provided at the frame. Typically, they can be in a fixed position, i.e. not movable with respect to the frame. These fixation elements are comparable to those described with respect to FIGS. 2 and 3; however with the difference that the fixation units do not have an edge contacting surface configured for contacting the edge of the substrate. That is, the elements 120 or 120A and 120 B shown in FIGS. 2 and 3, respectively, are either omitted or are displaced towards the frame (away from the substrate receiving area) such that no contact with the edge of the substrate is provided. According to typical embodiments, which can be combined with other embodiments described herein, the further fixation units 220 are provided and/or distributed along the sides of the frame 160, which are the same sides as the sides at which a first positioning element is provided. The omission of the edge contacting surface for the further fixation units 220 result in a predetermined position of the substrate defined by the first positioning elements 151.

As shown in FIG. 2, according to embodiments described herein, a fixation unit 120 includes a first fixation element 122 and a second fixation element 123. The first fixation element 122 has a substantially flat or planar first surface 124 for contacting a first substrate surface 102 of the substrate 101. The second fixation element 123 has a substantially flat or planar second surface 125 for contacting a second substrate surface 103 of the substrate 101 opposing the first surface 102. According to some embodiments, the first surface 124 and the second surface 125 are essentially parallel to each other.

During operation, i.e. when the substrate is carried by the carrier, the substrate 101 is interposed or sandwiched between the first fixation element 122 and the second fixation element 123. An edge, e.g. a lateral side, of the substrate 101 contacts an edge contacting surface 121 of the fixation unit 120. According to some embodiments, the edge contacting surface 121 is integrally formed with the first fixation element 122 or the second fixation element 123. The edge contacting surface can also be the surface of a stopper element provided in the fixation unit.

A force element 130 provides a fixation force 140 for the substrate 101 with at least one of the first and the second fixation element 122, 123. The fixation force 140 is for firmly holding the substrate 101 to reduce or even avoid bulging of the substrate 101 particularly during a deposition process.

Thereby, the force element is configured to provide together with at least one of the first and the second fixation element 122, 123 a sufficient moment to counteract forces generated due to stress in the substrate, e.g. due to the deposition of a layer. Accordingly, the force element is configured to provide for a substrate orientation at an outer substrate perimeter region, which is parallel to the carrier. That is, a stress, which tends to generate substrate bending, cannot result in displacement of the substrate with a rotational movement, wherein the substrate edge would be the rotation axis.

A magnitude of the fixation force 140 is selected such that, when the substrate 101 is subject to a moment 141, e.g. due to a stress applied to the substrate 101 by a deposition process, a vertical distance between the first fixation element 122 and the second fixation element 123 is kept substantially constant. Accordingly, by keeping said vertical distance substantially constant, the substrate 101 is firmly held by the first fixation element 122 and the second fixation element 123, whereby bulging of the substrate 101 is minimized or even avoided. Accordingly, a quality of the coated material layers is improved, and breaking of the substrate 101 is avoided.

The first fixation element 122 extends from the edge contact surface 121, which defines a contact position, by a first length L1 substantially parallel to the first substrate surface 102. The second fixation element 123 extends from the contact position by a second length L2 substantially parallel to the second substrate surface 103. The shorter length of the first length L1 and the second length L2, i.e. L1 in the example shown in FIG. 2, provides in combination with the fixation force 140 a moment.

In other words, when a moment 141 due to stress (e.g., forces) applied to the substrate 101 occurs, a moment defined by the shorter length of the first length L1 and the second length L2 and the fixation force 140 counteracts said moment 141. In order to prevent opening up of the gap between the first fixation element 122 and the second fixation element 123 (i.e. in order to keep the vertical distance between the first fixation element 122 and the second fixation element 123 constant), the magnitude of the fixation force 130 needs to be selected large enough.

When selecting the magnitude of the fixation force 140, the first and second lengths L1 and L2, particularly the shorter length of these, and typical moments 141 e.g. generated during a deposition process are considered. According to some embodiments, an upper limit of a moment 141 e.g. generated during a deposition process is considered.

As an example, for a substrate of GEN 8.5 (2500 x 2200 mm), a first length L1 of 3 mm, a substrate thickness of 0.3 mm, and a minimum layer thickness, a moment of 168 Nmm or a total fixation force of 56 N should be applied around the sides of the substrate to avoid bulging. According to a typical embodiment, which can be combined with other embodiments, described herein, the counter-moment of the fixation unit per unit length of the perimeter of the substrate should be at least 10 Nmm/m, for example 15 Nmm/m or above. Typical examples can be 20 Nmm/m, 30 Nmm/m or even 40 Nmm/m as a lower limit to reduce or avoid bending. Thereby, it has to be considered that the stress, and thus the forces bending the substrate, may depend on the substrate thickness, the substrate size, the layer thickness of the deposited layer(s) and other properties of the deposited layer(s), such as material matching of layers in layer stacks and the like.

Fixation forces 130 may be selected differently depending on at least one of a type of substrate (material, thickness, area size, etc.), a number of layers to be deposited on the substrate 101, a kind of material(s) to be deposited, thickness of the layer(s) to be deposited, kind of process chamber, process time, etc.

According to some embodiments, as it is for example shown in FIGS. 1a, 1b and 1c, one or more fixation units 120 provide the moment to be e.g. 10 Nmm per substrate edge unit length [1m] or above. An edge length unit may be a length of an edge of the substrate, e.g., a side of a substantially rectangular substrate. Thus, a normalization of the moment (counter moment) to the length of the substrate perimeter can be conducted such that the values of the moment can be normalized per 1 meter of the substrate perimeter length.

Regarding FIGS. 1a, 1b and 1c, a number of the fixation units 120 for each side of the substrate 101 can be determined based on a total fixation force to be applied to the substrate 101 (i.e., moment per substrate edge length unit). Moreover, according to some embodiments, a distribution of the fixation elements 120 over the substrate sides can be selected to maximize a reduction of bulging of the substrate 101.

According to some embodiments, the second fixation element 123 is fixed, i.e., substantially not movable, whereas the first fixation element 122 is movable substantially perpendicular to the substrate surfaces 102, 103. A force element 130 provides the fixation force 140 for the substrate 101 with at least one of the first and the second fixation element 122, 123.

According to some embodiments described herein, one or more force elements 130 provide the fixation force 140 to the second fixation element 121, which is movable, to press the substrate 101 against the second surface 125 of the second fixation element 123, which is fixed.

Alternatively, both the first fixation element 121 and the second fixation element 123 are moveable with respect to each other. In such a case, the one or more force elements 130 can provide the fixation force 140 to both the first fixation element 121 and the second fixation element 122. For example, a 2000 nm Cu-layer on a 0.7 mm Gen 8.5 glass would result in a moment of 500 Nmm/m, which is normalized to the substrate perimeter length. Thus, having a plurality of e.g. 56 fixation positions, a force element with 28 N would need to be provided.

According to some embodiments, which can be combined with other embodiments described herein, the force element 130 includes at least one spring element. However, the invention is not limited to spring elements, and other elements suitable for generating a fixation force might be used. Examples include, but are not limited to, levers, compression springs, piezoelectric devices and pneumatic devices.

According to some embodiments, which can be combined with other embodiments described herein, the edge contacting surface 121 is integrally formed with the first fixation element 122 or the second fixation element 123.

FIG. 3 illustrates another example of a fixation unit according to embodiments described herein.

As described above, according to embodiments, to avoid bending or bulging of the substrate 101, the substrate 101 is fixed with the fixation assembly including one or more fixation units 120.

According to some embodiments, which can be combined with other embodiments described herein, the fixation assembly includes two fixation units 120a and 120b. Both fixations units 120a, 120b are attached to the frame 160.

The first fixation unit 120a includes a first fixation element 122a and a second fixation element 123a. The second fixation unit 120b includes a first fixation element 122b and a second fixation element 123b. As shown in FIG. 2, in an assembled state, the substrate 101 is interposed between the first fixation element 122a and the second fixation element 123a of the first fixation unit 120a, and the first fixation element 122b and the second fixation element 123b of the second fixation unit 120b, respectively.

According to some embodiments, which can be combined with other embodiments described herein, the edge contacting surface 121 is provided by at least one stopping element 126. Each fixation unit 120a, 120b may include one or more stopping elements 126. According to some embodiments, the at least one stopping element 126 is fixedly attached to the first fixation element 122a, 122b of a respective fixation unit 120a, 120b. According to other embodiments, the at least one stopping element 126 is integrally formed with the first fixation element 122a, 122b of a respective fixation unit 120, i.e. the stopping unit 126 and the first fixation element form one single part.

According to some embodiments, which can be combined with other embodiments described herein, the first fixation elements 122a, 122b are fixed in position. The second fixation elements 123a, 123b are movable in a vertical direction, i.e., in a direction substantially perpendicular to the first surface 124 of the first fixation element 122a, 122b (or the first substrate surface 102) and/or to the second surface 125 of the second fixation element 123a, 123b (or the second substrate surface 103).

Each fixation unit 120a and 120b includes a force element 130 for providing a fixation force 140 for the substrate 101 with at least one of the first and the second fixation elements 122a, 122b, 123a, 123b. In FIG. 3, only the force element 130 of the second fixation unit 120b is shown, but, although not shown, another force element is provided for the first fixation unit 120a.

According to some embodiments, which can be combined with other embodiments described herein, the force element 130 is a spring element. As shown in FIG. 3, the force element 130 may be a pressure spring. However, the invention is not limited to spring elements, and other elements suitable for generating a fixation force might be used. Examples include, but are not limited to, levers, compression springs, piezoelectric devices and pneumatic devices.

The pressure spring 130 is connected to both the first fixation element 122a, 122b and the second fixation element 123a, 123b. According to some embodiments, which can be combined with other embodiments described herein, the first fixation elements 122a, 122b are fixed in position and the second fixation elements 123a, 123b are movable in the substantially vertical direction, as described above. The pressure spring 130 pulls the movable first fixation elements 122a, 122b towards the fixed second fixation elements 123a, 123b.

In FIG. 3, the first fixation unit 120a shows a situation where a substrate 101 is present (interposed) between the first fixation element 122a and the second fixation element 123a. As the pressure spring 130 pulls the first fixation element 122a towards the second fixation element 123a by exerting the fixation force 140, the first surface 124 of the first fixation element 122 contacts the first substrate surface 102, and the second surface 125 of the second fixation element 123 contacts the second substrate surface 103.

As a result, the substrate 101 is firmly held between the first fixation element 122a and the second fixation element 123a. When the substrate 101 experiences a moment 141 as shown in FIG. 2, e.g., due to stress applied to the substrate 121 during a deposition process, a bulging of the substrate 101 is minimized or even avoided by the application of the fixation force 140. Particularly, as explained above, the fixation force 140 is selected such that it can counteract typical moments generated during a deposition process. However, bending or budging may also occur due to the weight of the substrate itself, stress in the substrate itself, which can additionally be influenced by heating of the substrate. Accordingly, the embodiments of the invention can also be utilized for counter-acting on theses bending mechanisms.

In FIG. 3, the second fixation unit 120b shows a situation where no substrate 101 is present (interposed) between the first fixation element 122b and the second fixation element 123b. As the pressure spring 130 pulls the first fixation element 122b towards the second fixation element 123b by exerting the fixation force 140, the vertical distance between the first surface 124 of the first fixation element 122b and the second surface 125 of the second fixation element 123b is reduced compared to a case where a substrate 101 is present. The first surface 124 of the first fixation element 122b and the second surface 125 of the second fixation element 123b may even contact each other when no substrate is present.

Besides the benefits of the embodiments described herein, the design shown in FIG. 3 provides further improvements with respect to flexibility and/or handling. As shown in FIG. 3, a carrier according to embodiments described herein, can include a pin. The pin is connected to the second fixation unit. A spring element or another means for providing the force to the first fixation element and/or the second fixation element is provided on the pin or parallel to the pin. As shown in FIG. 3, a nut 131, which can be adjusted on a thread or another adjustable element, can be provided as a stop for the spring or the force element in general. Accordingly, the force provided for reducing the bending or bulging of the substrate can be easily adjusted.

Yet further, in the example shown in FIG. 3, the pin 131 can be easily actuated. For example, the pin is arranged such that when the carrier is moved against a surface, e.g. a flat surface of a handling system or even the floor of a facility, the fixation unit is arranged in an open position for insertion of the substrate, e.g. a glass substrate. Movement of the carrier away from the surface automatically closes the fixation unit by the force unit. Accordingly, the arrangement including a pin can be easily opened or closed by a handling system or even for manual loading, e.g. by arranging the carrier on the floor or leaning the carrier against another surface. The fixation unit moves in the closed position for processing the substrate upon moving the carrier away from the surface actuating the pin.

Accordingly, according to some embodiments, which can be combined with other embodiments described herein, at least one of the first fixation element and the second fixation element is movably provided. The movable fixation element is provided on a first side of the respective other fixation element in the direction of the movement. A pin or another protrusion extends beyond the other fixation element towards a second side opposing the first side.

According to some embodiments, which can be combined with other embodiments described herein, one or more fixation units 120 are provided. One or more fixation units 120 may provide a total fixation force corresponding to a moment of 10 Nmm per substrate edge length unit or above, as e.g. explained above.

According to some embodiments, which can be combined with other embodiments described herein, a support element 170 is provided. Support element 170 particularly allows for further reducing bulging of the substrate 101 by providing an additional supporting area. Thereby, the support element 170 can be considered a portion of one of the first or second fixation units and participates in providing a lever for the moment to avoid or reduce bending of the substrate.

According to different embodiments, a carrier 100 can be utilized for PVD deposition processes, CVD deposition processes, substrate structuring edging, heating (e.g. annealing) or any kind of substrate processing. Embodiments of carriers as described herein and methods for utilizing such carriers are particularly useful for non-stationary, i.e. continuous substrate processing. Typically, the carriers are provided for processing vertically oriented large area glass substrates. Non-Stationary processing typically requires that the carrier also provides masking elements for the process.

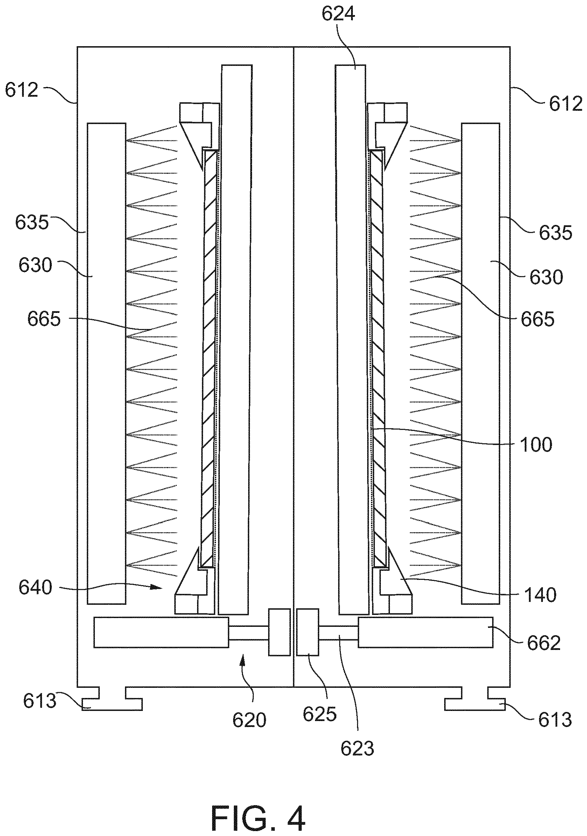

FIG. 4 shows a schematic view of a deposition chamber 600 according to embodiments. The deposition chamber 600 is adapted for a deposition process, such as a PVD or CVD process. A substrate 101 is shown being located within or at a carrier on a substrate transport device 620. A deposition material source 630 is provided in chamber 612 facing the side of the substrate to be coated. The deposition material source 630 provides deposition material 635 to be deposited on the substrate.

In FIG. 4, the source 630 may be a target with deposition material thereon or any other arrangement allowing material to be released for deposition on substrate 101. Typically, the material source 630 may be a rotatable target. According to some embodiments, the material source 630 may be movable in order to position and/or replace the source. According to other embodiments, the material source may be a planar target.

According to some embodiments, the deposition material 635 may be chosen according to the deposition process and the later application of the coated substrate. For instance, the deposition material of the source may be a material selected from the group consisting of: a metal, such as aluminum, molybdenum, titanium, copper, or the like, silicon, indium tin oxide, and other transparent conductive oxides. Typically, oxide-, nitride- or carbide-layers, which can include such materials, can be deposited by providing the material from the source or by reactive deposition, i.e. the material from the source reacts with elements like oxygen, nitride, or carbon from a processing gas. According to some embodiments, thin film transistor materials like siliconoxides, siliconoxynitrides, siliconnitrides, aluminumoxide, aluminumoxynitrides may be used as deposition material.

Typically, the substrate 101 is provided within or at the carrier 100, which can also serve as an edge exclusion mask, particularly for non-stationary deposition processes. Dashed lines 665 show exemplarily the path of the deposition material 635 during operation of the chamber 600. According to other embodiments, which can be combined with other embodiments described herein, the masking can be provided by a separate edge exclusion mask which is provided in the chamber 612. Thereby, a carrier according to embodiments described herein can be beneficial for stationary processes and also for non-stationary processes.

According to embodiments, which can be combined with other embodiments described herein, a fixation assembly firmly holds edges of a substrate particularly during a deposition process. Embodiments can provide a decrease in substrate breakage, particularly in light of the fact that the substrates are getting bigger in length and height, however, the thickness of the substrates decreases. The bulging, which might also affect the processing of the substrate, can be reduced by the carriers according to

While the foregoing is directed to embodiments of the invention, other and further embodiments of the invention may be devised without departing from the basic scope thereof, and the scope thereof is determined by the claims that follow.

## Claims

1. A carrier (100) for supporting a substrate (101) in a substrate processing chamber (600) comprises:
a substrate fixation assembly, wherein the substrate fixation assembly comprises one or more fixation units (120), wherein each fixation unit (120) comprises:
an edge contacting surface (121) configured for contacting the edge of the substrate (101) and defining a contact position;
a first fixation element (122) having a first surface (124) configured for contacting a first substrate surface (102) of the substrate (101), wherein the first fixation element (122) extends from the contact position by a first length (L1) substantially parallel to the first substrate surface (102);
a second fixation element (123) having a second surface (125) configured for contacting a second substrate surface (103) of the substrate (101), wherein the second substrate surface (103) opposes the first substrate surface (102) of the substrate (101), and wherein the second fixation element (123) extends from the contact position by a second length (L2) substantially parallel to the second substrate surface (103);
a force element (130) for providing a fixation force (140) for the substrate (101) with at least one of the first and the second fixation element (122, 123);
wherein the shorter length (L1, L2) of the first length (L1) and the second length (L2) provides in combination with the fixation force (140) a moment;
wherein the one or more fixation units (120) provide the moment to be 10 Nmm per substrate edge length unit, measured in meters, or above.

2. The carrier (100) according to claim 1, further comprising a frame (160) configured for receiving the substrate (101) in a substrate area thereof.

3. The carrier (100) according to claim 1 or 2, wherein the fixation assembly, and in particular the fixation unit (120), is fixed to the frame (160).

4. The carrier (100) according to any of claims 1 to 3, wherein the second fixation element (123) is fixed in position and the first fixation element (122) is moveable with respect to the second fixation element (123) in a direction substantially perpendicular to the second surface (125) of the second fixation element (123) or in a direction substantially perpendicular to the first substrate surface (102).

5. The carrier (100) according to any of claims 1 to 3, wherein the first fixation element (122) and the second fixation element (123) are both moveable with respect to each other in a direction substantially perpendicular to the first surface (124) of the first fixation element (122) and/or the second surface (125) of the second fixation element (123).

6. The carrier (100) according to any of claims 1 to 5, wherein the force element (130) is connected to the first fixation element (122) and/or the second fixation element (123).

7. The carrier (100) according to any of claims 1 to 6, wherein the force element (130) comprises at least one of a spring, a pressure spring, a lever, a piezoelectric device and a pneumatic device.

8. The carrier (100) according to any of claims 1 to 7, wherein the edge contacting surface (121) is integrally formed with either the first fixation element (122) or the second fixation element (123).

9. The carrier (100) according to any of claims 1 to 7, wherein the fixation unit (120) further comprises a stopping element (126) defining the edge contacting surface (121).

10. The carrier (100) according to claim 9, wherein the stopping element (126) is integrally formed with either the first fixation element (122) or the second fixation element (123).

11. The carrier (100) according to any of claims 1 to 10, further comprising a support element (170) configured to provide an additional supporting area for the substrate (101).

12. The carrier (100) according to claim 11, wherein the additional supporting area of the support element (170) is provided in a plane substantially parallel to the second surface (125) of the second fixation element (123).

13. The carrier (100) according to any of claims 1 to 12, further comprising:
one or more positioning elements (151, 152) attached to the frame (160) configured for positioning of the substrate (101) in a plane substantially parallel to the first and second substrate surfaces (102, 103).

14. The carrier (100) according to any of claims 1 to 13, wherein the at least one fixation unit (120) is configured for fixing the substrate (101) having a thickness of 0.1 mm to 1.8 mm.

15. An apparatus (600) for depositing a layer on a large area glass substrate (101), comprising:
a vacuum chamber (612) adapted for layer deposition therein,
a transport system (620) adapted for transportation of a carrier (100) according to any of claims 1 to 14; and
a deposition source (630) for depositing material forming the layer.

## Patentansprüche

1. Träger (100) zum Haltern eines Substrats (101) in einer Substratbearbeitungskammer (600), Folgendes aufweisend:
eine Substratbefestigungsbaugruppe, wobei die Substratbefestigungsbaugruppe eine oder mehrere Befestigungseinheit/en (120) aufweist, wobei jede Befestigungseinheit (120) aufweist:
eine Kantenberührungsfläche (121), die dazu ausgelegt ist, die Kante des Substrats (101) zu berühren und eine Kontaktposition zu definieren;
ein erstes Befestigungselement (122) mit einer ersten Fläche (124), die dazu ausgelegt ist, eine erste Substratfläche (102) des Substrats (101) zu berühren, wobei sich das erste Befestigungselement (122) von der Kontaktposition um eine erste Länge (L1) um Wesentlichen parallel zur ersten Substratfläche (102) erstreckt;
ein zweites Befestigungselement (123) mit einer zweiten Fläche (125), die dazu ausgelegt ist, eine zweite Substratfläche (103) des Substrats (101) zu berühren, wobei die zweite Substratfläche (103) der ersten Substratfläche (102) des Substrats (101) entgegengesetzt ist, und wobei sich das zweite Befestigungselement (123) von der Kontaktposition um eine zweite Länge (L2) im Wesentlichen parallel zur zweiten Substratfläche (103) erstreckt;
ein Kraftelement (130), um eine Befestigungskraft (140) für das Substrat (101) mit dem ersten und/oder zweiten Befestigungselement (122, 123) bereitzustellen;
wobei die kürzere Länge (L1, L2) der ersten Länge (L1) und der zweiten Länge (L2) im Kombination mit der Befestigungskraft (140) ein Moment bereitstellt;
wobei die eine oder die mehreren Befestigungseinheit/en (120) das Moment mit 10 Nmm pro Substratkantenlängeneinheit, gemessen in Metern, oder darüber bereitstellt bzw. bereitstellen.

2. Träger (100) nach Anspruch 1, darüber hinaus einen Rahmen (160) aufweisend, der dazu ausgelegt ist, das Substrat (101) in einem Substratbereich von diesem aufzunehmen.

3. Träger (100) nach Anspruch 1 oder 2, wobei die Befestigungsbaugruppe, und insbesondere die Befestigungseinheit (120), am Rahmen (160) befestigt ist.

4. Träger (100) nach einem der Ansprüche 1 bis 3, wobei das zweite Befestigungselement (123) positionsfixiert ist, und das erste Befestigungselement (122) in Bezug auf das zweite Befestigungselement (123) in einer Richtung im Wesentlichen senkrecht zur zweiten Fläche (125) des zweiten Befestigungselements (123) oder in einer Richtung im Wesentlichen senkrecht zur ersten Substratfläche (102) beweglich ist.

5. Träger (100) nach einem der Ansprüche 1 bis 3, wobei das erste Befestigungselement (122) und das zweite Befestigungselement (123) beide in Bezug aufeinander in einer Richtung im Wesentlichen senkrecht zur ersten Fläche (124) des ersten Befestigungselements (122) und/oder zur zweiten Fläche (125) des zweiten Befestigungselements (123) beweglich sind.

6. Träger (100) nach einem der Ansprüche 1 bis 5, wobei das Kraftelement (130) an das erste Befestigungselement (122) und/oder das zweite Befestigungselement (123) angeschlossen ist.

7. Träger (100) nach einem der Ansprüche 1 bis 6, wobei das Kraftelement (130) eine Feder, eine Druckfeder, einen Hebel, eine piezoelektrische Einrichtung und/oder eine pneumatische Einrichtung aufweist.

8. Träger (100) nach einem der Ansprüche 1 bis 7, wobei die Kantenberührungsfläche (121) integral mit entweder dem ersten Befestigungselement (122) oder dem zweiten Befestigungselement (123) ausgebildet ist.

9. Träger (100) nach einem der Ansprüche 1 bis 7, wobei die Befestigungseinheit (120) darüber hinaus ein Anschlagelement (126) aufweist, das die Kantenberührungsfläche (121) definiert.

10. Träger (100) nach Anspruch 9, wobei das Anschlagelement (126) integral mit entweder dem ersten Befestigungselement (122) oder dem zweiten Befestigungselement (123) ausgebildet ist.

11. Träger (100) nach einem der Ansprüche 1 bis 10, darüber hinaus ein Halterungselement (170) aufweisend, das dazu ausgelegt ist, eine zusätzliche Auflagefläche für das Substrat (101) bereitzustellen.

12. Träger (100) nach Anspruch 11, wobei die zusätzliche Auflagefläche des Halterungselements (170) in einer Ebene im Wesentlichen parallel zur zweiten Fläche (125) des zweiten Befestigungselements (123) vorgesehen ist.

13. Träger (100) nach einem der Ansprüche 1 bis 12, darüber hinaus aufweisend:
ein oder mehrere, am Rahmen (160) angebrachte/s Positionierungselement/e, das bzw. die dazu ausgelegt ist bzw. sind, das Substrat (101) in einer Ebene im Wesentlichen parallel zur ersten und zweiten Substratfläche (102, 103) zu positionieren.

14. Träger (100) nach einem der Ansprüche 1 bis 13, wobei die mindestens eine Befestigungseinheit (120) dazu ausgelegt ist, das Substrat (101) zu befestigen, das eine Dicke von 0,1 mm bis 1,8 mm hat.

15. Vorrichtung (600) zum Abscheiden einer Schicht auf einem großflächigen Glassubstrat (101), Folgendes aufweisend:
eine Vakuumkammer (612), die zu einer Schichtabscheidung in dieser angepasst ist,
ein Transportsystem (620), das zum Transport eines Trägers (100) nach einem der Ansprüche 1 bis 14 angepasst ist; und
eine Abscheidungsquelle (630) zum Abscheiden eines die Schicht bildenden Materials.

## Revendications

1. Support (100) destiné à supporter un substrat (101) dans une chambre de traitement de substrat (600), comprenant :
un ensemble de fixation de substrat, sachant que l'ensemble de fixation de substrat comprend une ou plusieurs unités de fixation (120), sachant que chaque unité de fixation (120) comprend :
une surface de mise en contact de bord (121) configurée pour mettre en contact le bord du substrat (101) et définir une position de contact ;
un premier élément de fixation (122) présentant une première surface (124) configurée pour mettre en contact une première surface de substrat (102) du substrat (101), sachant que le premier élément de fixation (122) s'étend depuis la position de contact à raison d'une première longueur (L1) sensiblement parallèle à la première surface de substrat (102) ;
un deuxième élément de fixation (123) présentant une deuxième surface (125) configurée pour mettre en contact une deuxième surface de substrat (103) du substrat (101), sachant que la deuxième surface de substrat (130) est opposée à la première surface de substrat (102) du substrat (101), et sachant que le deuxième élément de fixation (123) s'étend depuis la position de contact à raison d'une deuxième longueur (L2) sensiblement parallèle à la deuxième surface de substrat (103) ;
un élément de force (130) destiné à fournir une force de fixation (140) pour le substrat (101) avec au moins l'un du premier et du deuxième élément de fixation (122, 123) ;
sachant que la longueur plus courte (L1, L2) de la première longueur (L1) et de la deuxième longueur (L2) fournit, en combinaison avec la force de fixation (140), un couple ;
sachant que l'une ou les plusieurs unités de fixation (120) fournissent le couple pour qu'il soit de 10 Nmm par unité de longueur de bord de substrat, mesurée en mètres, ou plus.

2. Le support (100) selon la revendication 1, comprenant en outre un cadre (160) configuré pour recevoir le substrat (101) dans une zone de substrat de celui-ci.

3. Le support (100) selon la revendication 1 ou 2, sachant que l'ensemble de fixation, et en particulier l'unité de fixation (120), est fixé au cadre (160).

4. Le support (100) selon l'une quelconque des revendications 1 à 3, sachant que le deuxième élément de fixation (123) est fixe en position et le premier élément de fixation (122) est mobile par rapport au deuxième élément de fixation (123) dans une direction sensiblement perpendiculaire à la deuxième surface (125) du deuxième élément de fixation (123) ou dans une direction sensiblement perpendiculaire à la première surface de substrat (102).

5. Le support (100) selon l'une quelconque des revendications 1 à 3, sachant que le premier élément de fixation (122) et le deuxième élément de fixation (123) sont tous deux mobiles l'un par rapport à l'autre dans une direction sensiblement perpendiculaire à la première surface (124) du premier élément de fixation (122) et/ou la deuxième surface (125) du deuxième élément de fixation (123).

6. Le support (100) selon l'une quelconque des revendications 1 à 5, sachant que l'élément de force (130) est connecté au premier élément de fixation (122) et/ou au deuxième élément de fixation (123).

7. Le support (100) selon l'une quelconque des revendications 1 à 6, sachant que l'élément de force (130) comprend au moins un élément parmi un ressort, un ressort de pression, un levier, un dispositif piézoélectrique et un dispositif pneumatique.

8. Le support (100) selon l'une quelconque des revendications 1 à 7, sachant que la surface de mise en contact de bord (121) fait partie intégrante soit du premier élément de fixation (122) soit du deuxième élément de fixation (123).

9. Le support (100) selon l'une quelconque des revendications 1 à 7, sachant que l'unité de fixation (120) comprend en outre un élément de butée (126) définissant la surface de mise en contact de bord (121).

10. Le support (100) selon la revendication 9, sachant que l'élément de butée (126) fait partie intégrante soit du premier élément de fixation (122) soit du deuxième élément de fixation (123).

11. Le support (100) selon l'une quelconque des revendications 1 à 10, comprenant en outre un élément de support (170) configuré pour fournir une zone de support supplémentaire pour le substrat (101).

12. Le support (100) selon la revendication 11, sachant que la zone de support supplémentaire de l'élément de support (170) est disposée dans un plan sensiblement parallèle à la deuxième surface (125) du deuxième élément de fixation (123).

13. Le support (100) selon l'une quelconque des revendications 1 à 12, comprenant en outre :
un ou plusieurs éléments de positionnement (151, 152) attachés au cadre (160), configurés pour positionner le substrat (101) dans un plan sensiblement parallèle à la première et la deuxième surface de substrat (102, 103).

14. Le support (100) selon l'une quelconque des revendications 1 à 13, sachant que l'au moins une unité de fixation (120) est configurée pour fixer le substrat (101) ayant une épaisseur de 0,1 mm à 1,8 mm.

15. Appareil (600) destiné à déposer une couche sur un substrat en verre de vaste étendue (101), comprenant :
une chambre à vide (612) adaptée pour le dépôt de couche dans celle-ci,
un système de transport (620) adapté pour le transport d'un support (100) selon l'une quelconque des revendications 1 à 14 ; et
une source de dépôt (630) destinée à déposer du matériau formant la couche.
